# FASCICULE DE BREVET EUROPEEN

(11) **EP 2 786 414 B1**
(45) Date de publication et mention de la délivrance du brevet: **03.04.2019**
(21) Numéro de dépôt: 12801642.5
(22) Date de dépôt: 30.11.2012
(51) Int. Cl.: H01L 27/15, H01L 33/08, H01L 33/18, H01L 33/16, H01L 33/38, H01L 33/24, H01L 33/06

(54) **DISPOSITIF OPTOÉLECTRONIQUE COMPRENANT DES NANOFILS DE STRUCTURE C UR/COQUILLE**
OPTOELEKTRONISCHE VORRICHTUNG MIT NANODRÄHTEN MIT EINER KERN-/HÜLLENSTRUKTUR
OPTOELECTRONIC DEVICE COMPRISING NANOWIRES WITH A CORE/SHELL STRUCTURE

(30) Priorité: 01.12.2011 FR 1103670
(43) Date de publication de la demande: 08.10.2014
(73) Titulaire: Commissariat à l'Énergie Atomique et aux Énergies Alternatives, 75015 Paris (FR)
(72) Inventeur: GILET, Philippe, F-38470 Teche (FR); BAVENCOVE, Anne-Laure, F-31110 Moustajon (FR)
(74) Mandataire: Gevers & Orès
(86) Numéro de dépôt international: PCT/IB2012/056866
(87) Numéro de publication internationale: WO 2013/080174

(56) Documents cités:
- EP-A1- 2 357 676
- DE-A1-102010 012 711
- US-A1- 2002 145 148
- US-A1- 2003 107 047
- US-A1- 2011 012 167

## Description

L'invention concerne le domaine de l'optoélectronique et, en particulier, les émetteurs de lumière à base de nanofils présentant une structure du type coeur/coquille (ou core/shell dans la terminologie anglaise).

En effet, il est connu de réaliser des dispositifs optoélectroniques et notamment des diodes électroluminescentes (DEL ou LED dans la terminologie anglaise) à base de nanofils du type InGaN/GaN.

De façon générale, les nanofils peuvent présenter deux structures différentes, une structure axiale ou une structure radiale.

Dans les deux cas, le nanofil comporte une zone dopée n, une zone dopée p et, entre ces deux zones, une zone active non-intentionnellement dopée qui comporte des puits quantiques.

L'utilisation de InGaN pour la formation des puits quantiques est connue dans l'état de la technique. En augmentant la concentration en Indium, il est possible de diminuer le gap de ce matériau ternaire à partir du gap du GaN, dont la valeur est environ 3,5 eV, jusqu'au gap de l'InN, dont la valeur est environ 0,69 eV. Il est ainsi théoriquement possible de balayer la totalité du spectre visible.

Dans un nanofil à structure axiale, la zone active est orientée parallèlement au substrat de croissance des nanofils. Dans un nanofil à structure radiale, la zone active est épitaxiée autour du nanofil obtenu à partir du substrat de croissance.

La structure radiale obtenue est dite en coeur/coquille. Le terme « *nanofil* » sera également utilisé pour désigner la structure complète, comprenant à la fois le coeur, la zone active axiale et la coquille.

Les nanofils à structure axiale sont généralement obtenus par épitaxie par jets moléculaires (ou MBE dans la terminologie anglaise), tandis que les nanofils à structure radiale sont déposés par dépôt en phase vapeur par procédé chimique organométallique (MOCVD dans la terminologie anglaise).

D'après US 2003/107047 A1 il est connu d'utiliser des éléments semiconducteurs à structure cristalline de type Wurtzite pour émettre de la lumière. Toutefois, ce type d'élément ne constitue pas un nanofil de type « coeur/coquille » dont la zone active comprend une première région périphérique entourant le coeur des nanofils et une deuxième région supérieure située sur l'extrémité du coeur des nanofils.

Le document de brevet US 2002/0145148 décrit un dispositif d'émission lumineuse à semi-conducteur de type Wurtzite. Toutefois, ce dispositif ne comporte pas de nanofils à puits quantiques.

De nombreux documents décrivent des procédés permettant l'obtention de nanofils à zone active radiale.

On peut notamment citer le document US-7 521 274 qui décrit une méthode de croissance dite pulsée ou le document US-7 829 445 qui décrit une méthode de croissance sous flux d'ammoniac.

Les nanofils à structure radiale présentent plusieurs avantages par rapport aux nanofils à structure axiale.

On peut notamment citer une augmentation, par rapport à une même surface de substrat, de la surface de jonction et du volume de zone active, ainsi qu'une limitation des recombinaisons de surface et donc une augmentation du rendement d'électroluminescence.

Par ailleurs, la connexion électrique de nanofils à structure radiale est généralement réalisée selon une configuration en parallèle. Ainsi, une électrode supérieure permet l'injection des porteurs dans la coquille des nanofils, tandis qu'une électrode inférieure assure la connexion du coeur du nanofil. La différence de potentiel est alors la même aux bornes de chaque nanofil.

Les schémas de connexion en parallèle retenus dépendent des propriétés du coeur, de la coquille et du substrat utilisé.

On peut notamment citer le document WO2009/087319 qui décrit un schéma dans lequel l'électrode supérieure entoure la partie supérieure des nanofils tout en laissant découverte leur face supérieure. Le document US-2005/0253138 décrit, quant à lui, une électrode supérieure qui enrobe complètement la partie supérieure des nanofils.

De façon générale, pour assurer un éclairage, on souhaite disposer de systèmes efficaces émettant une lumière blanche. Or, les diodes électroluminescentes sont monochromatiques.

Différentes solutions ont donc été proposées dans l'état de la technique pour générer de la lumière blanche, à partir de DELs monochromatiques.

Pour les DELs blanches obtenues par une technologie planaire conventionnelle, une première solution consiste à combiner une diode émettant une longueur d'onde courte λ1, provenant par exemple d'une DEL bleue, avec un luminophore émettant dans une gamme de longueur d'onde longue complémentaire À2. Le luminophore consiste par exemple en du phosphore de type YAG:Ce émettant principalement dans le jaune.

La couleur de la lumière perçue par l'oeil humain (blanche plus ou moins prononcée) provient de la combinaison des deux longueurs d'onde λ1 et λ2.

Un exemple de dispositif optoélectronique à base de particules de phosphore est décrit dans le document de brevet US 2011/0012167 A1 qui vise à augmenter une surface d'émission étendue.

Cependant, les pertes d'efficacité liées au rendement de conversion du phosphore sont importantes et la qualité de l'émission est difficilement maîtrisable.

Pour ces DELs planaires, une deuxième solution consiste à utiliser au moins trois DELs émettant des longueurs d'onde visibles différentes qui se combinent pour donner une lumière blanche.

En pratique, une DEL émettant une lumière bleue est associée à une DEL émettant une lumière verte et à une DEL émettant une lumière rouge. Ces DELs sont réalisées dans des matériaux différents.

L'absence de luminophore et donc de phosphore permet de s'affranchir des pertes dues au phosphore. Cependant, en pratique, l'indice de rendu de couleur et la température de couleur (correspondant à la température du corps noir émettant le même spectre lumineux) dépendent de la proportion de chacune des composantes de lumière colorée. Or, cette proportion est difficilement maîtrisable dans un dispositif, chacune des LED présentant un comportement électrique différent sous injection électrique (décalage en longueur d'onde, vieillissement ...).

De plus, il est nécessaire d'associer des diodes monochromatiques présentant une efficacité quantique externe supérieure à 50%, pour les trois couleurs.

Or, la technologie planaire ne permet pas d'atteindre ces performances, surtout dans le domaine spectral vert-jaune où l'efficacité quantique externe des dispositifs chute autour de 10%.

En ce qui concerne les DELs à base de nanofils, deux solutions principales ont été proposées dans l'état de la technique pour générer de la lumière blanche.

La première solution consiste à associer de façon classique du phosphore à une structure à base de nanofil.

On peut, par exemple, citer le document US-2005/0208302 qui décrit une structure hétérogène comprenant un nanofil et une couche de phosphore sur l'extrémité ou sur la surface complète du nanofil.

Cette structure hétérogène présente les mêmes inconvénients qu'une structure comportant une DEL planaire et un luminophore.

Une autre solution consiste à ne pas utiliser de phosphore et à proposer des structures très spécifiques.

Ainsi, le document US-7 045 375 décrit un système d'émission de lumière blanche, dans lequel sont associées une structure de DEL planaire et des structures de DELs nanofils émettant des longueurs d'onde différentes.

Cette structure présente également des inconvénients liés à l'utilisation de matériaux différents dont le comportement électrique peut varier.

Le brevet EP 2 357 676 A1 décrit un dispositif optoélectronique présentant plusieurs ensembles de plots à semi-conducteurs présentant des diamètres et hauteurs différents en fonction de l'ensemble auxquels ils appartiennent de manière à émettre une longueur d'onde distincte.

On peut également citer le document EP-2 254 164 qui décrit un dispositif dans lequel sont associés des nanofils de différentes hauteurs et émettant différentes longueurs d'onde. On constate que, dans un tel dispositif, il est difficile de contrôler la hauteur des nanofils.

Le document de brevet DE-10 2010 012711 A1 décrit un dispositif optoélectronique comprenant une pluralité de nanofils à puits quantiques dont l'épaisseur de la couche active peut varier de manière à émettre à des longueurs différentes. Toutefois, ceci nécessite un contrôle précis de l'épaisseur de la zone active lors de la fabrication des nanofils. Ce dispositif ne permet pas de commander électriquement l'émission d'une lumière à longueurs d'ondes multiples.

Enfin, dans les dispositifs décrits dans l'état de la technique, les nanofils utilisés présentent une structure axiale. On a donc une perte de surface émissive par rapport à une structure planaire et donc une perte d'efficacité.

L'invention a pour objet de pallier ces inconvénients en proposant un dispositif optoélectronique permettant l'émission d'une lumière multi-longueurs d'onde et notamment d'une lumière blanche avec lequel la qualité de l'émission peut être facilement maîtrisée.

Ainsi, l'invention concerne un dispositif optoélectronique comprenant des moyens émetteurs de lumière sous la forme de nanofils présentant une structure du type coeur/coquille et obtenus sur un substrat, lesdits nanofils comportant une zone active comprenant au moins deux types de puits quantiques associés à des longueurs d'onde d'émission différentes et répartis dans au moins deux régions différentes de ladite zone active, une première région de la zone active des nanofils étant une partie périphérique et sensiblement verticale entourant au moins partiellement le coeur des nanofils et comportant des puits quantiques radiaux et une deuxième région de cette zone active étant une partie supérieure et sensiblement horizontale située sur l'extrémité du coeur des nanofils, avec des puits quantiques axiaux, le dispositif comprenant en outre une première zone de contact électrique sur le substrat et une deuxième zone de contact électrique sur les moyens émetteurs, cette deuxième zone étant agencée de telle sorte que, les moyens émetteurs étant répartis selon au moins deux ensembles, le contact électrique est réalisé pour chacun desdits au moins deux ensembles au moins au niveau d'une région différente de la zone active et par l'intermédiaire d'une couche conductrice contine, l'alimentation électrique étant commandée de façon à obtenir l'émission d'une lumière multi-longueurs d'onde.

Ce dispositif optoélectronique évite l'utilisation de phosphore et il est obtenu à partir d'un même substrat de croissance, tous les nanofils étant réalisés dans le même matériau.

Ceci permet d'éliminer les problèmes de vieillissement différent ou de comportement différent en fonction de la température qui sont rencontrés dans les dispositifs connus.

Par ailleurs, les nanofils sont obtenus au cours d'une même étape d'épitaxie, ce qui entraîne un gain de temps lors de la réalisation du dispositif, laquelle s'effectue à un coût réduit.

Enfin, la couleur de la lumière émise par le dispositif selon l'invention dépend directement du nombre de moyens émetteurs dans chacun des ensembles présents.

Dans une variante de réalisation du dispositif optoélectronique selon l'invention, la zone active comporte une troisième région, située entre les première et deuxième régions.

De façon avantageuse, la deuxième zone de contact électrique s'étend sur au moins une partie de la première région de la zone active des nanofils.

De façon avantageuse, le dispositif optoélectronique comprend une pluralité de parties connectées électriquement en parallèle et à l'intérieur desquelles les moyens émetteurs sont connectés en parallèle, le contact électrique de la deuxième zone de contact électrique étant réalisé au niveau d'une région différente de la zone active, pour deux parties adjacentes.

De façon préférée, lorsque la zone active des moyens émetteurs comporte deux régions distinctes, les moyens émetteurs du deuxième ensemble sont entourés d'un matériau électriquement isolant, à l'exception de leur face supérieure opposée au substrat, et la deuxième zone de contact électrique entoure complètement les moyens émetteurs du deuxième ensemble et est prévue sur le pourtour des moyens émetteurs du premier ensemble et en contact direct avec ceux-ci, sur une hauteur h correspondant à la première région de la zone active, de telle sorte que la partie supérieure de ces moyens émetteurs soit découverte.

Lorsque les moyens émetteurs comportent une zone active avec une troisième région, les moyens émetteurs d'un troisième ensemble sont entourés d'un matériau électriquement isolant sur la hauteur h, la deuxième zone de contact électrique étant prévue sur le pourtour des moyens émetteurs du troisième ensemble, sur une hauteur h₁ supérieure à h, de façon à ce que la partie supérieure des moyens émetteurs soit partiellement découverte.

Dans une autre variante de réalisation du dispositif optoélectronique selon l'invention, pour au moins certains des moyens émetteurs, la deuxième zone de contact électrique est agencée de telle sorte que le contact électrique est réalisé dans au moins deux régions de la zone active.

Dans cette variante, les moyens émetteurs sont répartis en au moins deux groupes électriquement indépendants, l'alimentation électrique étant commandée de telle sorte que, pour chacun desdits au moins deux groupes, des régions différentes de la zone active soient alimentées.

Enfin, la zone active des nanofils est, de préférence, réalisée en InGaN/GaN.

L'invention sera mieux comprise et d'autres buts, avantages et caractéristiques de celle-ci apparaîtront plus clairement à la lecture de la description qui suit et qui est faite au regard des dessins annexés sur lesquels :
- la figure 1 est une vue en coupe illustrant schématiquement un nanofil présentant une structure du type coeur/coquille, dont la zone active comporte deux régions différentes,
- la figure 2 est une vue schématique en coupe illustrant un dispositif optoélectronique selon l'invention,
- les figures 3a à 3h sont des vues en coupe illustrant différentes étapes d'un procédé de réalisation du dispositif optoélectronique illustré à la figure 2,
- la figure 4 illustre schématiquement un exemple de connexion électrique de nanofils d'un dispositif optoélectronique selon l'invention,
- la figure 5 est un schéma explicatif d'une première variante de réalisation du dispositif optoélectronique selon l'invention, réalisé avec des nanofils tels qu'illustrés à la figure 1,
- la figure 6 illustre un exemple de réalisation d'un dispositif optoélectronique selon l'invention, basé sur la variante illustrée à la figure 5,
- la figure 7 est une vue schématique en coupe illustrant un autre exemple d'un nanofil présentant une structure du type coeur/coquille, dans lequel la zone active comporte trois régions différentes,
- la figure 8 est une vue schématique en coupe d'une deuxième variante de réalisation d'un dispositif optoélectronique réalisé avec des nanofils tels qu'illustrés à la figure 7,
- la figure 9 représente une variante de réalisation du dispositif optoélectronique illustré à la figure 8,
- la figure 10 illustre une autre variante du dispositif optoélectronique selon l'invention concernant le substrat et
- la figure 11 illustre encore une autre variante du dispositif optoélectronique selon l'invention, dans laquelle les moyens émetteurs sont reliés en série.

Les éléments communs aux différentes figures seront illustrés par les mêmes références.

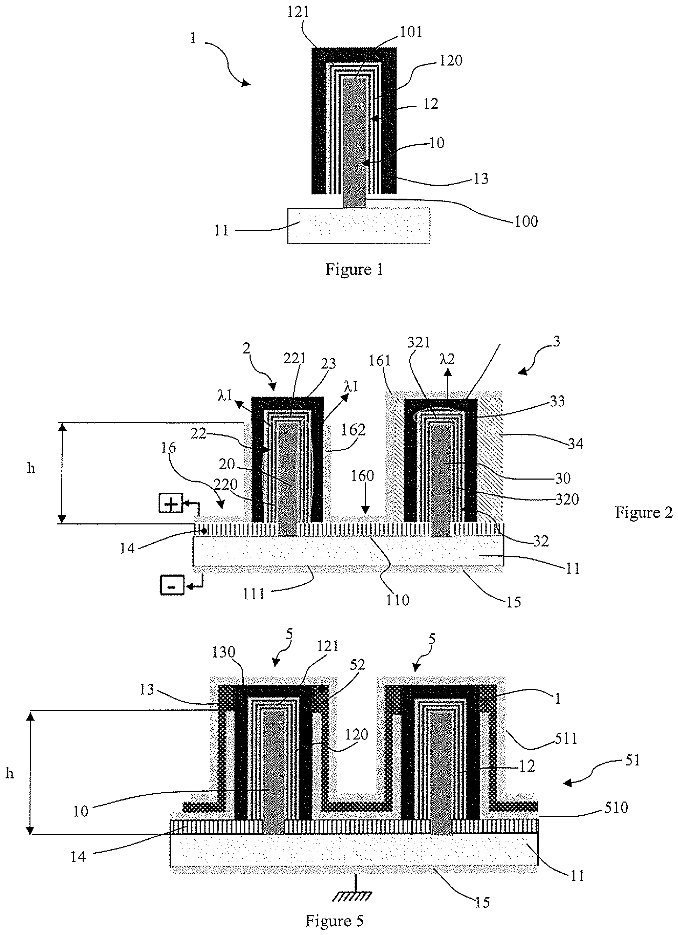

La figure 1 illustre un nanofil 1 présentant une structure du type coeur/coquille.

Dans l'ensemble de la description, le terme « *nanofil* » désignera une structure allongée, c'est-à-dire une structure dans laquelle le rapport hauteur sur diamètre (ou encore l'extension de la base largeur) est supérieur à 1.

Le coeur 10 du nanofil 1 est constitué d'un nanofil proprement dit, lequel a été obtenu par épitaxie perpendiculaire par rapport au substrat de croissance 11.

A titre d'exemple, le substrat est en silicium fortement dopé n et le coeur 10 est en nitrure de galium dopé n.

Le coeur 10 présente donc deux familles de plans cristallins distincts : les plans m sur la périphérie 100 du coeur et le plan c à la partie supérieure 101 du coeur, opposée au substrat.

La zone active 12 du nanofil est réalisée autour du coeur 10. Elle consiste en des puits quantiques déposés radialement autour du coeur et réalisés en InGaN/GaN et qui résultent d'une croissance selon des plans perpendiculaires au plan c, par exemple sur des plans m.

On peut distinguer deux familles de puits quantiques, selon le plan cristallographique sur lequel ils sont épitaxiés.

Ainsi, la zone active 12 du nanofil 1 comporte ici deux régions, une première région périphérique 120, dans laquelle les puits quantiques sont radiaux et une deuxième région supérieure 121 dans laquelle les puits quantiques sont axiaux.

La première région 120 s'étend sensiblement verticalement, c'est-à-dire sensiblement perpendiculairement par rapport au substrat 11. La deuxième région 121 s'étend sensiblement horizontalement, c'est-à-dire sensiblement parallèlement au substrat 11.

Il a déjà été établi que ces deux familles de puits ont des propriétés d'émission (longueur d'onde et efficacité quantique interne) qui sont largement dépendantes de la présence de champ piézoélectrique interne dans les puits quantiques.

On peut ainsi se référer à l'article de Lai et al, « Excitation current dépendent cathodoluminescence study of InGaN/GaN quantum wells grown on m-plane and c-plane GaN substrates », JAP 106 (2009) 113104.

Par ailleurs, les premières études de croissance de puits quantiques réalisés en InGaN/GaN et présentant une structure radiale semblent indiquer que les mécanismes de croissance dépendent des plans cristallographiques sur lesquels les puits sont épitaxiés.

On peut se référer à l'article de Bergbauer W. et al, « Continuous-flux MOVPE growth of position-controlled N-face GaN nanorods and embedded InGaN quantum wells », Nanotechnology 21 (2010) 305201.

Les inventeurs sont ainsi partis de l'hypothèse que la vitesse de croissance et l'incorporation d'indium sont différentes sur un plan c ou sur un plan m. Cette particularité conduit à des puits quantiques d'épaisseur et/ou de composition différentes et donc à l'émission à des longueurs d'onde différentes.

Les inventeurs ont étudié expérimentalement, par cathodoluminescence basse température, la différence d'émission entre les puits quantiques polaires axiaux et les puits quantiques non polaires radiaux sur des structures DELs du type nanofil obtenues par MOCVD, ces nanofils présentant une structure du type coeur/coquille avec une zone active constituée de puits quantiques InGaN/GaN.

Ces expériences ont montré que la différence de longueur d'onde d'émission entre les deux familles de puits quantiques était de l'ordre de 32 nm à 10 K.

Ainsi, les inventeurs ont mis en évidence qu'il est possible de disposer de nanofils présentant une structure du type coeur/coquille présentant des puits quantiques axiaux et des puits quantiques radiaux associés à des longueurs d'onde d'émission situées dans des domaines spectraux bien séparés.

De façon générale, on peut ainsi considérer que les deux longueurs d'onde correspondant aux deux types de puits quantiques sont non seulement différentes mais qu'il n'existe pas de recouvrement important entre les deux spectres émis par ces deux types de puits quantiques. En d'autres termes, la différence entre les deux longueurs d'onde est au moins égale à la demi-somme des largeurs des spectres à mi-hauteur.

Enfin, le nanofil comporte une coquille 13 qui est réalisée autour de la zone active 12. La coquille peut être réalisée en GaN dopé p.

La figure 2 illustre schématiquement un dispositif optoélectronique selon l'invention. Ce dispositif optoélectronique comporte ici deux moyens émetteurs de la lumière, du type du nanofil 1 illustré à la figure 1. Ces moyens émetteurs 2 et 3 comportent ici une structure similaire. Ils ne se distinguent que par la structure d'une de leur zone de contact électrique.

Bien entendu, un dispositif optoélectronique selon l'invention comportera, en pratique, plus de deux moyens émetteurs.

Les coeurs 20 et 30 des moyens émetteurs 2 et 3 sont constitués par un nanofil proprement dit qui a été épitaxié perpendiculairement par rapport au substrat de croissance 11, selon le masque de croissance isolant 14 qui est déposé sur la surface 110 du substrat.

Chaque moyen émetteur 2, 3 comporte une zone active 22, 32 qui entoure le coeur 20, 30, ainsi qu'une coquille 23, 33.

A l'intérieur de la zone active 22, 32, on peut distinguer deux régions correspondant à des puits quantiques associés à des longueurs d'onde d'émission différentes.

Ainsi, la région 220, 320 périphérique et sensiblement verticale comporte des puits quantiques radiaux et la région 221, 321 supérieure et sensiblement horizontale comporte des puits quantiques axiaux.

Les puits quantiques axiaux sont caractérisés par un degré de relaxation des contraintes plus important que les puits radiaux. Les inventeurs sont alors partis de l'hypothèse qu'il est théoriquement possible d'incorporer plus d'indium dans les puits quantiques axiaux. Ceci permet aux puits quantiques axiaux de générer des photons dont la longueur d'onde d'émission λ2 est supérieure à la longueur d'onde λ1 des photons générés par les puits quantiques radiaux.

Par ailleurs, les inventeurs ont constaté que la lumière émise par les puits quantiques radiaux dans une structure du type coeur/coquille est peu ou pas guidée par la géométrie filaire de la structure.

Ainsi, les photons de longueur d'onde À1 sortent des moyens émetteurs sans atteindre les puits quantiques axiaux, ce qui limite les phénomènes de réabsorption des photons constatés sur des structures classiques. Le rendement des moyens émetteurs est donc augmenté.

Le dispositif optoélectronique illustré à la figure 2 comporte deux zones de contact électrique.

Une première zone de contact électrique 15 est réalisée sur le substrat, du côté opposé aux moyens émetteurs 2 et 3. Elle s'étend sur toute la surface 111 du substrat 11.

Une deuxième zone de contact électrique 16 est réalisée sur les moyens émetteurs 2 et 3.

La figure 2 montre que le moyen émetteur 3 comporte, autour de la coquille 33, une gaine 34 en matériau isolant, à l'exception de la face supérieure 330 de la coquille qui est totalement dépourvue de matériau isolant.

Ainsi, la deuxième zone de contact électrique est prévue entre tous les moyens émetteurs. Cette partie 160 de la deuxième zone de contact électrique est en contact avec le masque de croissance isolant 14.

Dans la continuité de la partie 160, la deuxième zone de contact électrique entoure complètement le moyen émetteur 3. La partie 161 du contact électrique est donc isolée de la partie périphérique du moyen 3 par la gaine isolante 34, mais elle est directement en contact avec la face supérieure 330 de la coquille 33.

Enfin, également dans le prolongement de la partie 160 et en continuité avec elle, la deuxième zone de contact électrique 16 est prévue sur le pourtour du moyen émetteur 2 et en contact direct avec la coquille 23. Cependant, cette partie 162 de la deuxième zone de contact ne s'étend que sur une hauteur h du moyen émetteur 2, de telle sorte qu'elle ne s'étend pas au-delà du coeur 20, dans le sens axial du coeur, ou encore au-delà de la région périphérique 220 de la zone active 22.

Ainsi, la deuxième zone de contact électrique 16 est continue, sauf au niveau de la région supérieure 221 du moyen émetteur 2.

En d'autres termes, la deuxième zone de contact électrique s'étend entre tous les moyens émetteurs et au moins en partie le long de la région verticale 220, 320 des moyens émetteurs, au niveau de laquelle se situent des puits quantiques radiaux.

Ainsi, sur la région verticale 220, 320 des moyens émetteurs 2 et 3, la deuxième zone 16 est continue et sur la région supérieure 321 des moyens émetteurs 3, la deuxième zone 16 est également continue.

Cette structure de la deuxième zone de contact électrique se différencie donc de celle formée d'une succession de plots distincts.

Grâce à cette structure particulière de la deuxième zone de contact électrique 16, lorsqu'une différence de tension est appliquée entre les première et deuxième zones de contact électrique 15 et 16, le moyen émetteur 2 générera des photons de longueur d'onde d'émission λ1, tandis que le moyen émetteur 3 émettra des photons de longueur d'onde λ2.

Ainsi, la sensation de lumière qui sera perçue par un oeil humain proviendra de la combinaison des longueurs d'onde λ1 et λ2.

En pratique, le spectre macroscopique du dispositif optoélectronique selon l'invention est déterminé par le rapport du nombre de moyens émetteurs du type du moyen 2, sur le nombre de moyens émetteurs du type du moyen 3.

Ainsi, en modifiant ce rapport, il est possible de modifier également le spectre macroscopique du dispositif optoélectronique.

C'est donc en choisissant la structure de la deuxième zone de contact que l'on pourra également adapter le spectre macroscopique du dispositif optoélectronique.

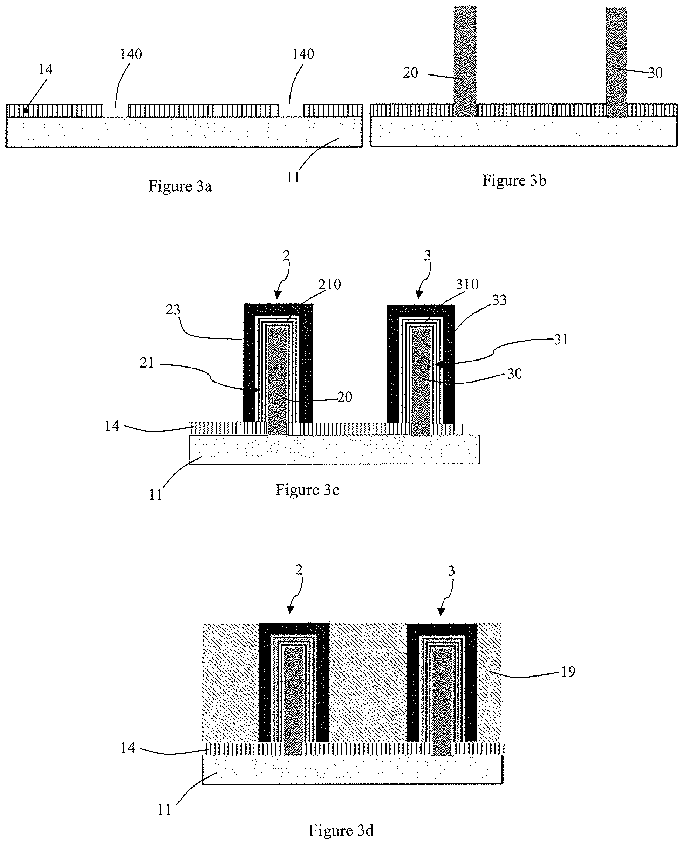

Un procédé d'obtention du dispositif optoélectronique illustré à la figure 2 va maintenant être décrit en référence aux figures 3a à 3h.

La figure 3a illustre une première étape de ce procédé dans lequel un masque de croissance est réalisé sur un substrat.

Ainsi, sur le substrat 11, est déposée une couche en un matériau électriquement isolant, afin d'éviter les courts-circuits entre la zone de contact électrique de type p qui sera ultérieurement formée et le substrat 11.

Le substrat peut être un substrat de silicium fortement dopé n et présenter une épaisseur de 400 µm.

Cette couche pourra notamment être réalisée en SixNyOz et, par exemple en SiO₂ ou SiN.

Un masque de gravure est ensuite appliqué sur cette couche de matériau isolant. Ce masque de gravure peut être configuré par des techniques classiques de nanoimprint ou de lithographie.

Une étape de gravure est ensuite réalisée, ce qui permet d'obtenir le masque de croissance isolant 14 illustré à la figure 3a. Ce masque de croissance se caractérise par des zones 140, dépourvues de tout matériau isolant.

La figure 3b illustre une étape de croissance localisée du coeur 20, 30 des nanofils qui vont former les moyens émetteurs 2, 3.

La croissance est réalisée au niveau des zones 140, selon des techniques classiques, de préférence non catalysées, telles que MOCVD, MBE ou HVPE (Hybrid Vapour Phase Epitaxy dans la terminologie anglaise ou épitaxie en phase vapeur).

Ces coeurs peuvent notamment être réalisés en nitrure de galium de type n.

Selon un moyen préféré de l'invention, la croissance est réalisée en MOCVD avec un faible rapport V/III et sous flux de silane et avec de l'azote comme gaz vecteur sous forte pression (proche de la pression atmosphérique).

Ils présentent une bonne continuité électrique avec le substrat de silicium 11 sur lequel ils sont épitaxiés.

Dans une variante, peut être intercalée entre le substrat 11 et les coeurs 20, 30, une fine couche de Ti, Pt, W, Al, B, SiC, SiN, AlN, Th, Mg₃N₂.

Elle permet de protéger le substrat 11 d'éventuelles attaques du gallium. Elle assure également une bonne interface pour la croissance des nanofils.

Dans ce cas, la couche doit être suffisamment fine pour que la continuité électrique entre les coeurs des nanofils et le substrat ne soit pas modifiée.

La figure 3c illustre une autre étape du procédé dans laquelle est réalisée la croissance de la zone active et de la coquille des nanofils.

Au cours de cette étape, est déposée radialement la zone active 21, 31, par exemple constituée d'une couche relativement épaisse d'InGaN ou de puits quantiques en InGaN/GaN.

Selon le procédé de croissance préféré, la croissance des puits quantiques s'effectue en augmentant le rapport V/III et en diminuant la pression de travail, en gardant ou non le flux de silane et avec de l'azote comme gaz vecteur.

La coquille 23, 33 est ensuite réalisée autour de la zone active. La coquille est réalisée en GaN (ou InGaN) de type p.

Selon le procédé de croissance préféré, le dopage p s'effectue avec un fort rapport V/III, sous faible pression, avec éventuellement un flux de silane et avec de l'hydrogène en gaz vecteur.

Une DEL avec une jonction pn est ainsi formée.

Par ailleurs, les conditions de croissance des puits quantiques des zones actives pourront être modifiées afin de changer la diffusion des espèces le long des parois du coeur et ainsi choisir de favoriser l'incorporation d'indium dans les puits axiaux ou radiaux de la zone active. En effet, les inventeurs ont constaté que l'incorporation d'indium pouvait être favorisée dans les deux types de puits, après être partis de l'hypothèse que seuls les puits quantiques axiaux étaient concernés. Ceci permettra d'encore mieux différencier les longueurs d'onde λ1 et λ2 associées aux puits quantiques.

Ainsi, à la fin de cette étape, les puits quantiques radiaux et les puits quantiques axiaux présenteront une longueur d'onde d'émission différente.

La figure 3d illustre une étape de dépôt d'une couche 19 de matériau électriquement isolant.

Ce matériau pourra par exemple être constitué d'un polymère ou de SiO₂.

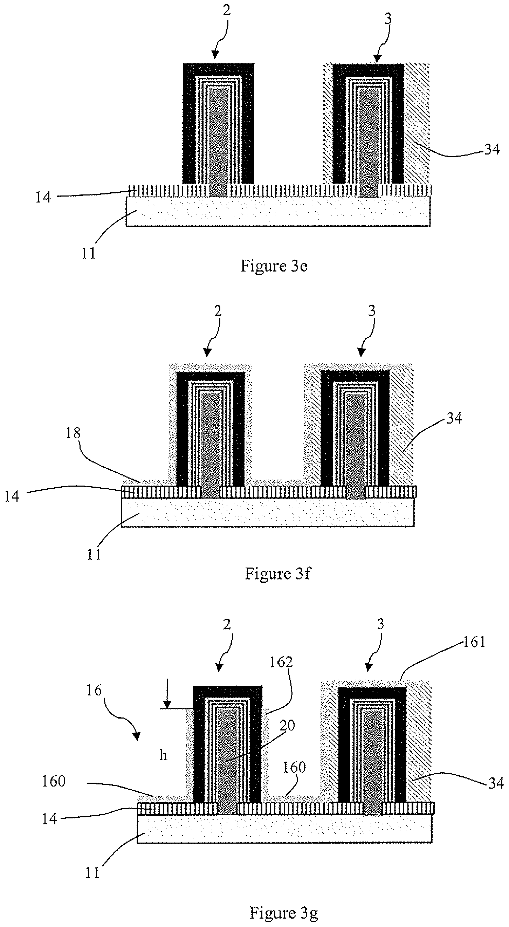

Cette couche 19 est ensuite gravée par une technique classique de lithographie de façon à maintenir une gaine 34 autour du moyen émetteur 3, comme l'illustre la figure 3e.

Les figures 3f et 3g illustrent l'étape de formation de la zone de contact électrique sur les moyens émetteurs 2 et 3.

Dans une première étape, illustrée à la figure 3f, une couche 18 en un matériau conducteur est formée sur toute la surface du masque de croissance 14 et donc autour des moyens émetteurs 2 et 3. Cette couche 18 est donc continue.

Le matériau conducteur est semi-transparent pour permettre l'extraction de la lumière depuis les moyens émetteurs 2 et 3.

Ainsi, cette couche 18 peut par exemple se présenter sous la forme d'une fine couche métallique (Ni/Au, Pd/Au ou Pt/Au) ou encore une couche d'ITO (Indium Tin Oxyde dans la terminologie anglaise).

Dans une deuxième étape, la couche 18 est gravée dans la partie supérieure du moyen émetteur 2. Cette gravure peut être réalisée au cours d'une étape classique de lithographie.

Ainsi, à l'issue de ces deux étapes, la zone de contact 16 est réalisée. Il s'agit d'un contact électrique de type p.

Comme expliqué en référence à la figure 2, cette deuxième zone de contact comporte des parties 160 en contact avec le masque 14, une partie 161 entourant complètement le moyen émetteur 3 et une partie 162 qui ne s'étend que sur la hauteur h du moyen émetteur 2, de telle sorte que la zone de contact électrique ne s'étend pas au-delà du coeur 20 du moyen émetteur 2. Les parties 161 et 162 sont dans la continuité des parties 160.

Ainsi, la zone de contact électrique 16 forme un contact dit périphérique sur le moyen émetteur 2, par la partie 162, et un contact dit planaire sur le moyen émetteur 3, par la partie 161.

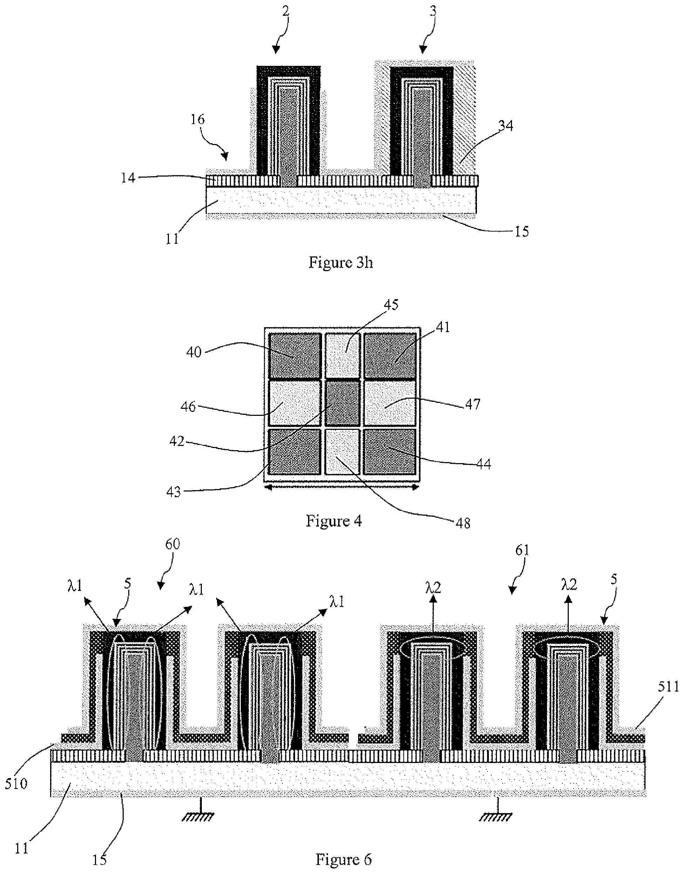

La figure 3h illustre une dernière étape du procédé dans lequel est réalisée une autre zone de contact électrique 15 sur le substrat, du côté opposé aux moyens émetteurs 2 et 3.

Cette autre zone de contact électrique pourra être obtenue par le dépôt d'une couche métallique, par exemple en Ni/Au.

Comme indiqué précédemment, un dispositif optoélectronique comportera une pluralité de moyens émetteurs 2, 3.

Deux types de schéma de connexion électrique peuvent alors être envisagés.

Les différents moyens émetteurs peuvent être connectés individuellement l'un à l'autre en série.

La figure 4 illustre un autre type de schéma de connexion, dans lequel un dispositif optoélectronique est constitué de neuf parties différentes : les parties 40 à 44 ne comprennent que des moyens émetteurs du type du moyen 2, c'est-à-dire des nanofils pour lesquels la zone de contact électrique 16 forme un contact périphérique et les parties 45 à 48 qui comprennent exclusivement des moyens émetteurs du type du moyen 3, c'est-à-dire des nanofils comportant un contact électrique planaire.

A l'intérieur de chaque partie, les moyens émetteurs sont connectés électriquement en parallèle et les différentes parties sont également connectées entre elles en parallèle.

Ainsi, pour deux parties adjacentes, le contact électrique de la deuxième zone de contact électrique est réalisé au niveau de régions différentes de la zone active.

La figure 5 est un schéma explicatif d'une première variante de réalisation d'un dispositif optoélectronique selon l'invention.

Dans cette variante du dispositif optoélectronique illustré à la figure 2, tous les moyens émetteurs peuvent générer des photons de longueur d'émission λ1 ou des photons de longueur d'onde λ2.

Ainsi, le dispositif optoélectronique comprend une pluralité de moyens émetteurs 5 comprenant chacun un nanofil 1, tel qu'illustré à la figure 1. Les nanofils sont obtenus par croissance à partir du substrat 11, une première zone de contact électrique 15 étant constituée sur la face du substrat 11, opposée au nanofil 1.

Le moyen émetteur 5 se distingue du moyen émetteur 2 ou 3, par la structure de la deuxième zone de contact électrique.

En pratique, cette deuxième zone de contact électrique 51 est réalisée en deux parties 510 et 511.

La première partie 510 réalise un contact électrique périphérique autour des nanofils 1, du type de celui réalisé pour le moyen émetteur 2.

Ainsi, cette partie 510 est en contact avec le masque isolant 14 et elle est directement en contact avec la partie périphérique de la coquille 13. En d'autres termes, la partie 510 réalise un contact électrique sur au moins une partie de la première région 120 de la zone active 12 correspondant à une hauteur h du nanofil 1, de telle sorte qu'elle ne s'étend pas au-delà du coeur 10 du nanofil 1.

Par ailleurs, une couche de matériau isolant 52 est présente autour des nanofils 1, à l'exception de la face supérieure 130 de la coquille 13 qui est totalement dépourvue de matériau isolant.

La deuxième partie 511 recouvre tous les moyens émetteurs 5 et elle est en contact avec l'ensemble de la couche 52, là où elle est présente, ou avec la face supérieure 130 de la coquille 13, laquelle est dépourvue de matériau isolant. La partie 511 est donc isolée de la partie périphérique du nanofil 1 par la couche isolante 52, mais elle est directement en contact électrique avec la face supérieure 130 de la coquille. Cette partie 511 réalise donc un contact électrique similaire à celui qui est présent sur le moyen émetteur 3.

Ainsi, la partie 510 est continue sauf au niveau de la région supérieure 121 ou encore au-delà du coeur 10, alors que la partie 511 est totalement continue.

Grâce à la structure de la zone 51, un même groupe de moyens émetteurs 5 pourra générer des photons de longueur d'onde λ1, en appliquant une différence de tension appropriée entre les zones de contact électrique 15 et 510, ou des photons de longueur d'onde d'émission λ2, lorsqu'une différence de tension appropriée est appliquée entre les zones de contact électrique 15 et 511. Un même groupe de moyens émetteurs 5 pourra donc émettre soit uniquement des photons de longueur d'onde d'émission λ1, soit uniquement des photons de longueur d'onde d'émission λ2.

Un dispositif optoélectronique selon l'invention sera ainsi obtenu en associant au moins deux ensembles de moyens émetteurs 5, ces deux ensembles étant électriquement indépendants.

Un tel exemple d'un dispositif optoélectronique selon l'invention est illustré à la figure 6.

Ce dispositif optoélectronique comprend ainsi deux groupes 60 et 61 de moyens émetteurs 5, ces deux ensembles étant électriquement indépendants. Bien entendu, le dispositif optoélectronique pourra comporter plus de deux groupes de moyens émetteurs.

L'alimentation électrique du premier groupe 60 est commandée de telle sorte qu'une différence de tension est appliquée entre la première zone de contact électrique 15 et la partie 510 de la deuxième zone de contact 51. Ainsi, les moyens émetteurs 5 du groupe 60 généreront des photons de longueur d'onde d'émission λ1.

Par contre, l'alimentation électrique des moyens émetteurs 5 du deuxième groupe 61 est commandée de telle sorte qu'une différence de tension est appliquée entre la première zone de contact électrique et la partie 511 de la deuxième zone de contact électrique 51. Les moyens émetteurs 5 du deuxième groupe 61 émettront donc des photons de longueur d'onde λ2.

Le spectre macroscopique du dispositif optoélectronique obtenu pourra être contrôlé en modulant les tensions de fonctionnement appliquées à chacun des groupes 60 et 61. En effet, l'intensité de la lumière émise par chaque groupe dépend du courant qui traverse les moyens émetteurs et donc de la tension à leurs bornes.

Ce spectre macroscopique dépend également du nombre de moyens émetteurs présents dans chaque groupe.

Enfin, si le nombre de moyens émetteurs présents dans chaque groupe est différent, le spectre macroscopique peut également être modifié en inversant le schéma de connexion, de telle sorte que le premier groupe 60 émette des photons de longueur d'onde λ2 et que le deuxième groupe 61 émette des photons de longueur d'onde λ1.

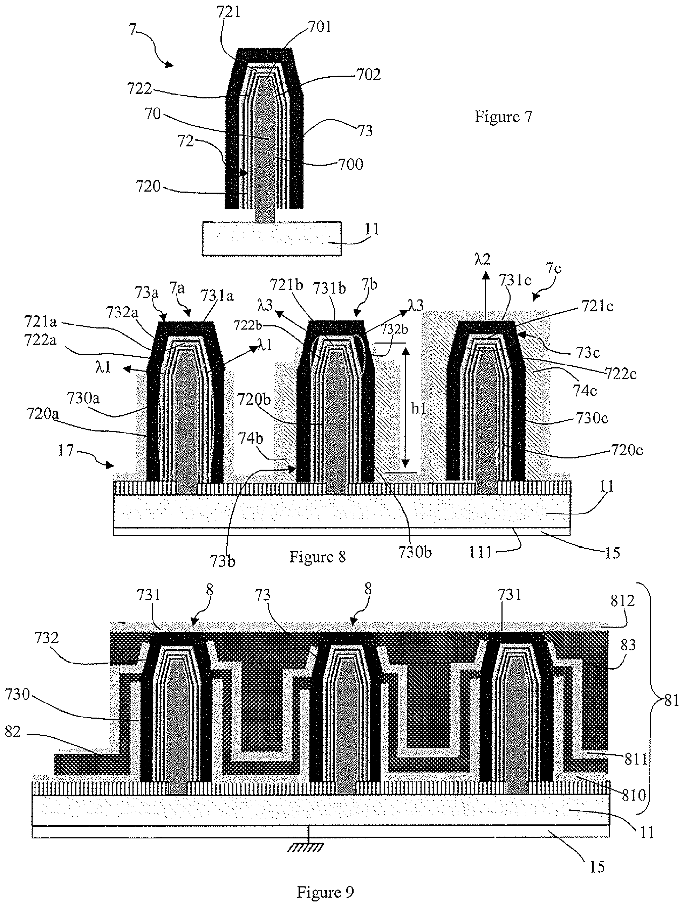

Il est maintenant fait référence à la figure 7 qui illustre un nanofil 7 présentant également une structure coeur/coquille.

Le coeur 70 du nanofil est constitué d'un nanofil proprement dit, lequel a été obtenu par épitaxie perpendiculaire par rapport au substrat de croissance 11.

Dans cet exemple, le coeur 70 présente trois plans cristallographiques : les plans m sur la périphérie 700 du coeur, les plans c à la partie supérieure 701 du coeur, opposée au substrat, ainsi que les plans r, sur la partie tronconique 702 du coeur 70, située entre la périphérie 700 et la partie supérieure 701. Cette forme particulière du coeur 70 peut être obtenue dans des conditions particulières de croissance. On peut à cet égard se référer à l'article de Bergbauer W et al. mentionné plus haut.

La référence 72 désigne la zone active du nanofil qui est réalisée autour du coeur 70.

Cette zone active comporte trois familles de puits quantiques, selon le plan cristallographique sur lequel ils sont épitaxiés. Ces trois familles sont réparties dans trois régions différentes : une première région périphérique 720, dans laquelle les puits quantiques sont radiaux, une deuxième région 721, dans laquelle les puits quantiques sont axiaux et une troisième région 722, dans laquelle les puits quantiques sont inclinés selon les plans r.

La première région 720 s'étend sensiblement verticalement, c'est-à-dire sensiblement perpendiculairement par rapport au substrat 11. La deuxième région 721 s'étend sensiblement horizontalement, c'est-à-dire sensiblement parallèlement au substrat. Enfin, la troisième région 722 s'étend de façon inclinée par rapport au substrat, cette troisième région reliant les première et deuxième régions.

La figure 8 illustre schématiquement un dispositif optoélectronique selon l'invention qui comporte trois moyens émetteurs de lumière du type du nanofil 7 illustré à la figure 7.

Ces moyens émetteurs 7a, 7b et 7c se distinguent l'un de l'autre par la structure de leur deuxième zone de contact, la première zone de contact 15 étant réalisée sur la face 111 du substrat 11 opposée au nanofil et étant continue.

Bien entendu, un dispositif optoélectronique selon l'invention comportera, en pratique, plus de trois moyens émetteurs du type des moyens 7a, 7b et 7c.

Ainsi, chacun des moyens émetteurs 7a à 7c présente une zone active comportant trois régions correspondant à des puits quantiques associés à des longueurs d'onde d'émission différentes. Cette zone active comporte une région 720a à 720c périphérique et sensiblement verticale, susceptible de générer des photons de longueur d'onde d'émission λ1, une région 721a à 721c supérieure et sensiblement horizontale, susceptible de générer des photons de longueur d'onde d'émission λ2 et une région 722a à 722c intermédiaire et inclinée, susceptible de générer des photons de longueur d'onde d'émission λ3.

La deuxième zone de contact électrique 17 va maintenant être décrite plus en détail.

La figure 8 montre que le moyen émetteur 7b comporte, dans la partie périphérique 730b de la coquille 73b, une gaine 74b de matériau isolant.

Par ailleurs, le moyen émetteur 7c comporte, autour de la coquille 73c, une gaine 74c de matériau isolant, à l'exception de la face supérieure 731c de la coquille 73c, laquelle est totalement dépourvue de matériau isolant.

La deuxième zone de contact électrique 17 est prévue sur les moyens émetteurs 7a à 7c et elle est donc en contact avec le masque 14 entre ces moyens. Elle est réalisée à partir d'une couche continue qui est ensuite gravée.

Ainsi, la deuxième zone de contact électrique entoure complètement le moyen émetteur 7c. Elle est donc isolée électriquement du moyen 7c, à l'exception de la face supérieure 731c du moyen émetteur, avec laquelle elle est directement en contact.

Par ailleurs, cette deuxième zone de contact électrique est prévue sur le pourtour de la partie périphérique 730a de la coquille 73a et directement en contact électrique avec celle-ci. Cependant, la deuxième zone de contact électrique ne s'étend pas autour de la partie supérieure du moyen 7a, définie par la partie intermédiaire 732a et la partie supérieure 731a de la coquille 73a, ou encore au-delà de la région périphérique 720a de la zone active.

En ce qui concerne le moyen émetteur 7b, la deuxième zone de contact électrique s'étend autour de la gaine isolante 74b. Elle s'étend également partiellement sur la partie intermédiaire 732b de la coquille 73b. En d'autres termes, la deuxième zone de contact est prévue sur le pourtour du moyen émetteur 7b, sur une hauteur h1, de façon à ce que la partie supérieure des moyens émetteurs soit partiellement découverte. On comprend ici par la partie supérieure du moyen 7b, la partie 732b qui se termine par la face supérieure 731b de la coquille 73b.

Ainsi, la deuxième zone de contact 17 est une couche qui s'étend sur tous les moyens émetteurs, sauf au niveau de la région supérieure 721b du moyen émetteur 7b et des régions supérieure et intermédiaire 721a et 722a du moyen émetteur 7a.

En d'autres termes, la deuxième zone 17 s'étend entre tous les moyens émetteurs et sur au moins une partie de la région verticale 720a, 720b et 720c des moyens émetteurs, au niveau de laquelle se situent les puits quantiques radiaux. Sur la région verticale 720a, 720b et 720c des moyens émetteurs, la couche 17 est donc continue. Sur la région supérieure 721c du moyen émetteur 7c et sur la région intermédiaire 722b du moyen émetteur 7b, elle est également continue.

Grâce à cette structure particulière de la deuxième zone de contact électrique 17, une différence de tension entre les première et deuxième zones de contact 15 et 17 provoque la génération de photons de longueur d'onde d'émission λ1 par le moyen émetteur 7a, de longueur d'onde d'émission λ3 par le moyen émetteur 7b et de longueur d'onde λ2 par le moyen émetteur 7c.

Ainsi, la sensation de lumière qui sera perçue par un oeil humain proviendra de la combinaison des longueurs d'onde λ1, λ2 et λ3.

La lumière émise par le dispositif selon la figure 8 sera de meilleure qualité que celle émise par le dispositif selon la figure 1, en termes d'index de rendu des couleurs (CRI dans la terminologie anglaise et de température de couleur corrélée (CCT dans la terminologie anglaise).

Comme expliqué en référence à la figure 2, le spectre macroscopique de ce dispositif optoélectronique est déterminé par le nombre de moyens émetteurs correspondant à chacun des types 7a, 7b et 7c.

Un procédé d'obtention du dispositif optoélectronique illustré à la figure 8 se déduit simplement de celui qui a été décrit en référence aux figures 3a à 3h.

On se réfère maintenant à la figure 9 qui illustre une variante de réalisation du dispositif optoélectronique selon la figure 8. Cette variante est similaire à celle qui a été illustrée à la figure 5.

En effet, la figure 9 montre un groupe de moyens émetteurs qui comportent chacun les trois types de contact électrique décrits pour les moyens 7a à 7c, en ce qui concerne la deuxième zone de contact électrique 81.

La première zone de contact électrique 15 est, quant à elle, réalisée sur le substrat 11, du côté opposé aux moyens émetteurs 8.

Chacun des moyens émetteurs 8 comporte un nanofil 7, tel qu'illustré à la figure 7 et qui ne sera pas de nouveau décrit en détail.

La deuxième zone de contact électrique 81 est constituée de trois parties 810, 811 et 812.

La première partie 810 réalise un contact électrique autour de la partie périphérique 730 de la coquille 73 des nanofils, comme cela a été expliqué pour les moyens émetteurs 7a.

Une couche de matériau isolant 82 est présente sur la première partie 810 de la deuxième zone de contact électrique, à l'exception de la partie intermédiaire 732 et de la face supérieure 731 de la coquille 73. Cette couche 82 crée donc une gaine isolante autour des nanofils 7, similaire à la gaine 74b décrite pour le moyen émetteur 7b.

La deuxième partie 811 de la deuxième zone de contact électrique 81 s'étend sur cette couche 82 et elle s'étend également partiellement sur la partie intermédiaire 732 de la coquille 73.

En d'autres termes, la partie supérieure des nanofils 7, constituée de la partie intermédiaire 732 et de la face supérieure 731 de la coquille, est en partie dépourvue de contact électrique.

Ainsi, cette deuxième partie 811 réalise un contact électrique similaire à celui qui a été décrit pour le moyen émetteur 7b.

Enfin, une deuxième couche 83 de matériau isolant est déposée sur la deuxième partie 811. Ainsi, seule la face supérieure 731 de la coquille 73 des nanofils 7 est dépourvue de matériau isolant.

La troisième partie 812 de la deuxième zone de contact électrique est déposée de façon continue sur la couche de matériau isolant 83. Elle est donc directement en contact électrique avec la face supérieure 731 de la coquille des nanofils 7.

Ainsi, chacun des moyens émetteurs 8 comporte les trois types de contact électrique de la deuxième zone de contact électrique qui ont été décrits pour les moyens 7a, 7b et 7c.

En pratique, les trois moyens émetteurs 8 illustrés à la figure 9 peuvent donc émettre des photons de longueur d'onde d'émission λ1, si une différence de tension est appliquée entre la première zone de contact électrique 15 et la première partie 810 de la deuxième zone de contact électrique 81. Une différence de tension appliquée entre les zones de contact 15 et 811 permettra de générer des photons de longueur d'onde d'émission λ3. Enfin, une différence de tension appliquée entre les zones de contact électrique 15 et 812 permettra de générer des photons de longueur d'onde d'émission λ2.

Comme expliqué en référence à la figure 6, un dispositif optoélectronique selon l'invention pourra être constitué de plusieurs groupes de moyens émetteurs 8, ces groupes étant électriquement indépendants.

Les remarques faites pour le dispositif illustré à la figure 6 sont également valables pour le dispositif illustré à la figure 9.

Dans tous les modes de réalisation illustrés, le contact électrique est réalisé sur au moins une région de la zone active et par l'intermédiaire d'une couche conductrice continue. Ceci présente un avantage par rapport à un contact électrique réalisé par l'intermédiaire de plots distincts. En effet, des plots sont d'une réalisation plus complexe et nécessitent ensuite une connexion filaire pour les connecter entre eux.

Il faut encore noter que ces plots sont généralement obtenus par une technique dite lift-off. Or, cette technique ne peut pas être mise en oeuvre sur une surface verticale, typiquement sur les régions périphériques des zones actives correspondant à un plan m.

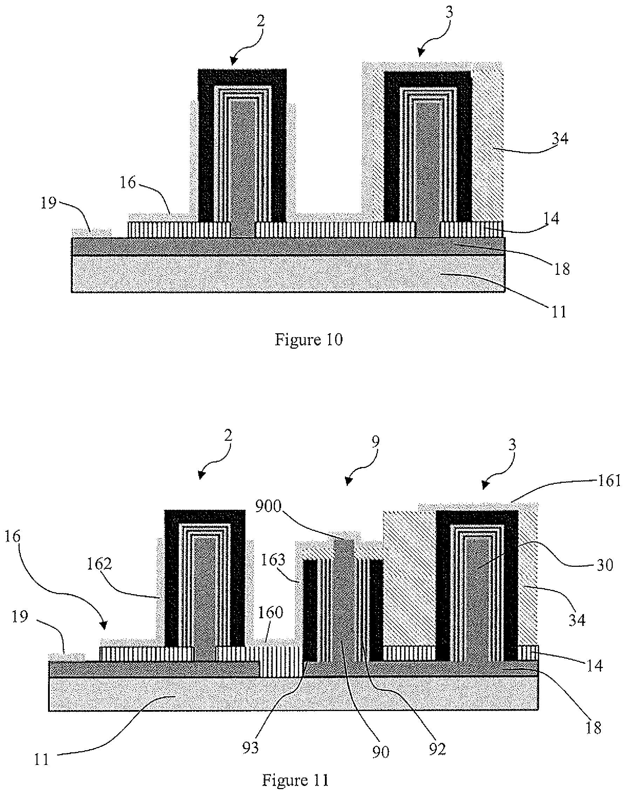

La figure 10 illustre une autre variante de l'invention dans laquelle la croissance des nanofils de GaN dopé n est réalisée sur un substrat 18 en GaN dopé n.

Dans ce cas, le substrat 11 n'est pas nécessairement électriquement conducteur et peut, par exemple, être réalisé en saphir.

La deuxième zone de contact électrique 16, de type p, est réalisée comme décrit précédemment.

Par contre, la première zone de contact électrique 19 de type n, est réalisée sur le substrat 18. Ceci nécessite une étape préalable de gravure du masque de croissance 14 et de la première zone de contact électrique 16.

Il est maintenant fait référence à la figure 11 qui montre une variante du dispositif illustré à la figure 10, dans laquelle est prévue une connexion électrique en série des moyens émetteurs.

Le dispositif comprend deux moyens émetteurs 2 et 3 entre lesquels est disposé un nanofil 9 dont le coeur 90 est inactif optiquement, car le courant ne traverse pas la jonction pn.

La deuxième zone de contact électrique 16 forme un contact périphérique sur le moyen émetteur 2, par la partie 162, et un contact planaire sur le moyen émetteur 3, par la partie 161.

Entre ces deux parties 161 et 162, la deuxième zone 16 comporte une partie 160 en contact avec le masque de croissance, laquelle se prolonge par une partie 163 qui vient en contact avec le coeur 90 du nanofil 9.

La figure 11 montre que la partie supérieure de la partie active 92 et de la coquille 93 du nanofil 9 a été retirée et que l'isolant 34 est présent non seulement autour du moyen émetteur 3 mais aussi autour du coeur 90 du nanofil dans cette partie supérieure.

Par contre, la face supérieure 900 du coeur 90 est en contact direct avec la partie 163 de la deuxième zone de contact électrique. De cette façon, il est établi une liaison électrique entre la zone de contact 162 de type p du moyen émetteur 2 et la zone de contact de type n du moyen émetteur 3. En effet, le coeur 90 du nanofil 9 est connecté au coeur 30 du moyen émetteur 3 par le substrat 18. Ceci assure la mise en série des moyens émetteurs 2 et 3.

Cette variante du dispositif présente l'avantage d'augmenter la tension de fonctionnement et de la rapprocher de la tension du secteur. Le dispositif présente ainsi un meilleur rendement.

Les signes de référence insérés après les caractéristiques techniques figurant dans les revendications ont pour seul but de faciliter la compréhension de ces dernières et ne sauraient en limiter la portée.

## Revendications

1. Dispositif optoélectronique comprenant des moyens émetteurs (2, 3 ; 5; 7a, 7b, 7c; 8) de lumière sous la forme de nanofils (1; 7) présentant une structure du type coeur/coquille et réalisés sur un substrat (11), lesdits nanofils comportant une zone active (12;22; 32; 72) comprenant au moins deux types de puits quantiques associés à des longueurs d'onde d'émission différentes et répartis dans au moins deux régions différentes (120, 121 ; 220, 221; 320, 321; 720, 721, 722) de ladite zone active, une première région (120; 220; 320; 720) de la zone active (12; 22 ;32; 72) des nanofils (1, 7) étant une partie périphérique et sensiblement verticale entourant au moins partiellement le coeur (10; 20; 30;70) des nanofils et comportant des puits quantiques radiaux et une deuxième région (121;221; 321; 721) de cette zone active étant une partie supérieure et sensiblement horizontale située sur l'extrémité du coeur des nanofils, avec des puits quantiques axiaux, le dispositif comprenant en outre une première zone (15) de contact électrique sur le substrat (11) et une deuxième zone (16 ; 51 ; 17 ; 81) de contact électrique sur les moyens émetteurs,
ledit dispositif étant **caractérisé en ce que** ladite deuxième zone de contact électrique est agencée de telle sorte que, les moyens émetteurs sont répartis selon au moins deux ensembles, le contact électrique étant réalisé pour chacun desdits au moins deux ensembles au niveau d'une région différente de la zone active et par l'intermédiaire d'une couche conductrice continue, et **en ce que** la zone active des moyens émetteurs comporte deux régions distinctes, les moyens émetteurs (3) du deuxième ensemble sont entourés d'un matériau électriquement isolant (34), à l'exception de leur face supérieure (330) opposée au substrat, et la deuxième zone de contact électrique entoure complètement les moyens émetteurs du deuxième ensemble et est prévue sur le pourtour des moyens émetteurs (2) du premier ensemble et en contact direct avec ceux-ci, sur une hauteur h correspondant à la première région de la zone active, de telle sorte que la partie supérieure de ces moyens émetteurs (2) soit découverte, l'alimentation électrique étant commandée de façon à obtenir l'émission d'une lumière multi-longueurs d'onde.

2. Dispositif optoélectronique selon la revendication 1, dans lequel la zone active (72) comporte une troisième région (722), située entre les première et deuxième régions.

3. Dispositif optoélectronique selon la revendication 1 ou 2, dans lequel la deuxième zone de contact électrique s'étend sur au moins une partie de la première région de la zone active des nanofils.

4. Dispositif optoélectronique selon l'une des revendications 1 à 3 comprenant une pluralité de parties (40 à 48) connectées électriquement en parallèle et à l'intérieur desquelles les moyens émetteurs sont connectés en parallèle, le contact électrique de la deuxième zone de contact électrique étant réalisé au niveau d'une région différente de la zone active, pour deux parties adjacentes.

5. Dispositif optoélectronique selon la revendication 1, dans lequel les moyens émetteurs comportent une zone active avec une troisième région, les moyens émetteurs (7b) d'un troisième ensemble sont entourés d'un matériau électriquement isolant sur la hauteur h, la deuxième zone de contact électrique étant prévue sur le pourtour des moyens émetteurs (7b) du troisième ensemble, sur une hauteur h₁ supérieure à h, de façon à ce que la partie supérieure des moyens émetteurs soit partiellement découverte.

6. Dispositif optoélectronique selon l'une des revendications 1 à 5, dans lequel, pour au moins certains des moyens émetteurs (5, 8), la deuxième zone de contact électrique comprend au moins deux parties (510, 511 ; 810, 811, 812) et est agencée de telle sorte que le contact électrique est réalisé dans au moins deux régions de la zone active, une couche isolante (52 ; 82, 83) étant prévue entre lesdites au moins deux parties.

7. Dispositif optoélectronique selon la revendication 6, dans lequel les moyens émetteurs sont répartis en au moins deux groupes (60, 61) électriquement indépendants, l'alimentation électrique étant commandée de telle sorte que, pour chacun desdits au moins deux groupes, des régions différentes de la zone active soient alimentées en courant.

8. Dispositif optoélectronique selon l'une des revendications 1 à 7, dans lequel la zone active des nanofils est réalisée en InGaN/GaN.

## Patentansprüche

1. Optoelektronische Vorrichtung, umfassend Licht-Emittiermittel (2, 3; 5; 7a, 7b, 7c; 8) in der Form von Nanodrähten (1; 7), die eine kern-/hüllenartige Struktur aufweisen und auf einem Substrat (11) realisiert sind, wobei die Nanodrähte eine aktive Zone (12; 22; 32; 72) einschließen, umfassend mindestens zwei Arten von Quantensenken, die mit unterschiedlichen Emissionswellenlängen verknüpft sind und in mindestens zwei unterschiedliche Regionen (120, 121; 220, 221; 320, 321; 720, 721, 722) der aktiven Zone aufgeteilt sind, wobei eine erste Region (120; 220; 320; 720) der aktiven Zone (12; 22; 32; 72) der Nanodrähte (1, 7) ein Umfangsteil und im Wesentlichen vertikal ist und mindestens teilweise den Kern (10; 20; 30; 70) der Nanodrähte umgibt und radiale Quantensenken einschließt, und wobei eine zweite Region (121; 221; 321; 721) dieser aktiven Zone ein oberes Teil und im Wesentlichen horizontal ist und auf dem Ende des Kerns der Nanodrähte liegt, mit axialen Quantensenken, wobei die Vorrichtung weiter eine erste elektrische Kontaktzone (15) auf dem Substrat (11) und eine zweite elektrische Kontaktzone (16; 51; 17; 81) auf den Emittiermitteln umfasst,
wobei die Vorrichtung **dadurch gekennzeichnet ist, dass** die zweite elektrische Kontaktzone so angeordnet ist, dass die Emittiermittel gemäß mindestens zweier Anordnungen aufgeteilt sind, wobei der elektrische Kontakt für jede der mindestens zwei Anordnungen hinsichtlich einer Region, die sich von der aktiven Zone unterscheidet, und mithilfe einer durchgehenden leitfähigen Schicht realisiert ist, und dadurch, dass die aktive Zone der Emittiermittel zwei verschiedene Regionen einschließt, die Emittiermittel (3) der zweiten Anordnung mit Ausnahme ihrer dem Substrat gegenüberliegenden oberen Seite (330) von einem elektrisch isolierenden Material (34) umgeben sind, und die zweite elektrische Kontaktzone die Emittiermittel der zweiten Anordnung vollständig umgibt und auf der Umrandung der Emittiermittel (2) der ersten Anordnung und in direktem Kontakt mit diesen auf einer Höhe h, die einer ersten Region der aktiven Zone entspricht, so vorgesehen ist, dass der obere Teil dieser Emittiermittel (2) unbedeckt ist, wobei die elektrische Versorgung gesteuert wird, sodass die Emission eines Lichts mit mehrfacher Wellenlänge erhalten wird.

2. Optoelektronische Vorrichtung nach Anspruch 1, wobei die aktive Zone (72) eine dritte Region (722) einschließt, die zwischen der ersten und zweiten Region liegt.

3. Optoelektronische Vorrichtung nach Anspruch 1 oder 2, wobei die zweite elektrische Kontaktzone sich über mindestens einen Teil der ersten Region der aktiven Zone der Nanodrähte erstreckt.

4. Optoelektronische Vorrichtung nach einem der Ansprüche 1 bis 3, umfassend eine Vielzahl von Teilen (40 bis 48), die elektrisch parallel geschaltet sind und innerhalb derer die Emittiermittel parallel geschaltet sind, wobei der elektrische Kontakt der zweiten elektrischen Kontaktzone hinsichtlich einer Region, die sich von der aktiven Zone unterscheidet, für zwei angrenzende Teile realisiert ist.

5. Optoelektronische Vorrichtung nach Anspruch 1, wobei die Emittiermittel eine aktive Zone mit einer dritten Region einschließen, die Emittiermittel (7b) einer dritten Anordnung von einem elektrisch isolierendem Material auf der Höhe h umgeben sind, wobei die zweite elektrische Kontaktzone auf der Umrandung der Emittiermittel (7b) der dritten Anordnung auf einer Höhe h₁ grösser als h vorgesehen ist, sodass der obere Teil der Emittiermittel teilweise unbedeckt ist.

6. Optoelektronische Vorrichtung nach einem der Ansprüche 1 bis 5, wobei für mindestens gewisse der Emittiermittel (5, 8) die zweite elektrische Kontaktzone mindestens zwei Teile (510, 511; 810, 811, 812) umfasst und so angeordnet ist, dass der elektrische Kontakt in mindestens zwei Regionen der aktiven Zone realisiert wird, wobei eine isolierende Schicht (52; 82, 93) zwischen den mindestens zwei Teilen vorgesehen ist.

7. Optoelektronische Vorrichtung nach Anspruch 6, wobei die Emittiermittel in mindestens zwei elektrisch unabhängige Gruppen (60, 61) aufgeteilt sind, wobei die elektrische Versorgung so gesteuert ist, dass für jede der mindestens zwei Gruppen unterschiedliche Regionen der aktiven Zone mit Strom versorgt werden.

8. Optoelektronische Vorrichtung nach einem der Ansprüche 1 bis 7, wobei die aktive Zone der Nanodrähte in InGaN/GaN realisiert ist.

## Claims

1. Optoelectronic device comprising light-emitting means (2, 3; 5; 7a, 7b, 7c; 8) in the form of nanowires (1; 7) having a core/shell-type structure and produced on a substrate (11), said nanowires comprising an active zone (12; 22; 32; 72) comprising at least two types of quantum wells associated with different emission wavelengths and distributed among at least two different regions (120, 121; 220, 221; 320, 321; 720, 721, 722) of said active zone, a first region (120; 220; 320; 720) of the active zone (12; 22; 32; 72) of the nanowires (1, 7) being a peripheral and substantially vertical part surrounding at least partially the core (10; 20; 30; 70) of the nanowires and comprising radial quantum wells and a second region (121; 221; 321; 721) of this active zone being an upper and substantially horizontal part located at the end of the core of the nanowires, with axial quantum wells, the device further comprising a first electrical contact zone (15) on the substrate (11) and a second electrical contact zone (16; 51; 17; 81) on the emitting means,
said device being **characterised in that** said second electrical contact zone is arranged such that the emitting means are distributed among at least two sets, the electrical contact being achieved for each of said at least two sets at the level of a different region of the active zone by means of a continuous conductive layer, and **in that** the active zone of the emitting means comprises two separate regions, the emitting means (3) of the second set are surrounded by an electrically insulating material (34), with the exception of the upper face (330) thereof located opposite the substrate, and the second electrical contact zone completely surrounds the emitting means of the second set and is provided on the periphery of the emitting means (2) of the first set and in direct contact with said emitting means, over a height h corresponding to the first region of the active zone, so that the upper part of these emitting means (2) is bare, the electrical supply of power being controlled so as to achieve multi-wavelength light emission.

2. Optoelectronic device according to claim 1, wherein the active zone (72) comprises a third region (722) located between the first and second regions.

3. Optoelectronic device according to claim 1 or 2, wherein the second electrical contact zone extends over at least one part of the first region of the active zone of the nanowires.

4. Optoelectronic device according to any of claims 1 to 3 comprising a plurality of parts (40 to 48) that are electrically connected in parallel and wherein the emitting means are connected in parallel, the electrical contact of the second electrical contact zone being made at the level of a different region of the active zone, for two adjacent parts.

5. Optoelectronic device according to claim 1, wherein the emitting means comprise an active zone with a third region, the emitting means (7b) of a third set are surrounded by an electrically insulating material over the height h, the second electrical contact zone being provided on the periphery of the emitting means (7b) of the third set, on a height h₁, greater than h, so that the upper part of the emitting means is partially bare.

6. Optoelectronic device according to any of claims 1 to 5, wherein, for at least some of the emitting means (5, 8), the second electrical contact zone comprises at least two parts (510, 511; 810, 811, 812) and is arranged so that the electrical contact is achieved in at least two regions of the active zone, an isolating layer (52; 82, 83) being provided between said at least two parts.

7. Optoelectronic device according to claim 6, wherein the emitting means are distributed among at least two groups (60, 61) electrically independent from one another, the electric supply being controlled such that, for each said at least two groups, different regions of the active zone are supplied with an electrical current.

8. Optoelectronic device according to any of claims 1 to 7, wherein the active zone of the nanowires is made of InGaN/GaN.
